# EUROPÄISCHE PATENTANMELDUNG

(11) **EP 0 722 090 A2**
(43) Veröffentlichungstag der Anmeldung: **17.07.1996**
(21) Anmeldenummer: 95119080.0
(22) Anmeldetag: 04.12.1995
(51) Int. Cl.: G01R 1/04

(54) **Haltevorrichtung für flächenförmige Prüflinge**

(30) Priorität: 10.01.1995 DE 19500416
(71) Anmelder: atg test systems GmbH, D-97877 Wertheim (DE)
(72) Erfinder: Prokopp, Manfred, D-97877 Wertheim (DE)
(74) Vertreter: Grosse, Rainer, Dipl.-Ing.

(57) **Zusammenfassung**

Die Erfindung betrifft eine Haltevorrichtung für flächenförmige Prüflinge, insbesondere Leiterplatten, die mittels einer elektrischen Kontaktierungsvorrichtung für Prüfzwecke von Kontaktfingern (10) verfahrbarer Positionierglieder (5) kontaktiert werden, wobei die Haltevorrichtung den Prüfling (3) auf seinen beiden, einander gegenüberliegenden Oberflächen mit Haltemitteln abstützt, wobei mindestens eines der Haltemittel als elektrisch nicht leitende, von den Kontaktfingern (10) durchstoßbare Folie (21) ausgebildet ist oder daß zumindest ein Haltemittel aus einem Vakuumsauger (27) gebildet wird.

## Beschreibung

Die vorliegende Erfindung betrifft eine Haltevorrichtung für flächenförmige Prüflinge, insbesondere Leiterplatten, die mittels einer elektrischen Kontaktierungsvorrichtung für Prüfzwecke von Kontaktfingern verfahrbarer Positionierglieder kontaktiert werden.

Es ist bekannt, zum Beispiel als kaschierte Leiterplatten ausgebildete Prüflinge insbesondere vor ihrer Bestückung mit elektronischen Bauteilen einer Prüfung auf Fehlerfreiheit, gegebenenfalls auf Kurzschluß, Isolationswiderstand und/oder Leiterbahnwiderstand zu unterziehen. Hierzu können sogenannte Adapter eingesetzt werden, die eine Vielzahl von Federkontaktstiften aufweisen, welche die Verbindung eines Prüffeldkontaktrasters zu Kontaktstellen des Prüflings herstellen, welche außerhalb dieses Rasters liegen. Nach einem anderen Prüfverfahren werden für den Test Kontaktierungsvorrichtungen eingesetzt, die verfahrbare Sondenpaare aufweisen. Jede Sonde besteht aus einem entlang zweier senkrecht aufeinanderstehender Koordinaten verfahrbaren Positionierglied, das einen Kontaktfinger aufweist. Hieraus resultiert auch die Benennung "Fingertester" für eine derartige Vorrichtung. Dieser Kontaktfinger wird nach Anfahren der gewünschten Position abgesenkt, so daß er auf die entsprechende Kontaktstelle dem Prüflings aufsetzt. Die beiden, dem Sondenpaar zugeordneten Kontaktfinger sind Bestandteil eines Prüfstromkreises. Die für den Prüfvorgang von den Kontaktfingern anzufahrenden Positionen werden von einem Rechner vorgegeben, in dem das Prüfprogramm gespeichert ist.

Selbst relativ einfach aufgebaute Prüflinge, zum Beispiel mit einer relativ kleinen Anzahl von Leiterbahnen versehene Leiterplatten, erfordern eine nicht unerhebliche Anzahl von Prüfschritten und damit Kontaktierungen mittels der Kontaktfinger. Da die Prüfzeit möglichst kurz sein soll, wird eine hohe Positioniergeschwindigkeit der Positionierglieder eingesetzt und somit der zeitliche Abstand zwischen zwei Messungen minimiert. Zu einer sicheren Kontaktierung muß der Kontaktfinger mit einem bestimmten Kontaktdruck auf den Prüfling aufgesetzt werden. Dabei verursacht dieser Kontaktierungsdruck, insbesondere bei etwas dünneren Leiterplatten und insbesondere in mittleren Bereichen der Leiterplatte, eine gewisse Durchbiegung und gegebenenfalls eine Schwingungsanregung. Findet nun die nächste Kontaktierung in unmittelbarer Nachbarschaft der vorhergehenden Kontaktierung statt, so kann es passieren, daß der zuvor durchgebogene Bereich des Prüflings noch nicht in seine Ruhelage zurückgekehrt ist, so daß der Kontaktfinger bei dieser erneuten Kontaktierung die zu messende Leiterbahn beziehungsweise deren Kontaktstelle entweder nur teilweise oder gar nicht trifft beziehungsweise eine Überbrückung zweier sehr dicht nebeneinanderliegender Leiterbahnen verursacht.

Bisher hat man sich damit beholfen, den Prüfling zwischen zwei Halteplatten einzuspannen. Um auf der/den abgestützten Oberfläche/n des Prüflings Kontaktierungen durchführen zu können, werden die Halteplatten mit Freibohrungen an den jeweiligen Kontaktierungsstellen versehen. Diese Lösung ist aufwendig. Dennoch kann auch hierbei eine gewisse Durchbiegung des kontaktierten Bereichs erfolgen, da oftmals die Oberfläche des Prüflings auf der Oberfläche der Halteplatte zumindest bereichsweise nicht plan aufliegt. Deshalb weist der Prüfling Bereiche auf, die keine unmittelbare Abstützung durch die Halteplatte erfahren und somit dem Kontaktierungsdruck der Kontaktfinger nachgeben können. Der Prüfling kann also in Schwingungen geraten und die sichere Kontaktierung verschlechtern beziehungsweise verhindern.

Der Erfindung liegt daher die Aufgabe zugrunde, eine Haltevorrichtung für flächenförmige Prüflinge der eingangs genannten Art zu schaffen, die eine gute Stabilisierung des Prüflings mit geringem Aufwand schafft und damit die Kontaktierungssicherheit erhöht.

Diese Aufgabe wird erfindungsgemäß dadurch gelöst, daß mindestens eines der Haltemittel als elektrisch nicht leitende, von den Kontaktfingern durchstoßbare Folie ausgebildet ist. Die erfindungsgemäße fest am Prüfling anliegende Folie sorgt dafür, daß der Prüfling stabilisiert wird und somit dem Kontaktierungsdruck nicht so leicht nachgibt, indem eine geringe Elastizität der Folie einer Durchbiegung der Leiterplatte aufgrund einer Nichtdehnung oder nur geringen Dehnung der Folie entgegenwirkt. Selbst bei Unebenheiten der Oberfläche des Prüflings wird diese Stabilisierungswirkung erreicht, da sich die Folie direkt an die Oberfläche anschmiegt und den Unebenheiten somit folgt. Freiräume zwischen Prüfling und Folie entstehen also nicht.

Die Verwendung einer erfindungsgemäßen, von den Kontaktfingern durchstoßbaren Folie hat den Vorteil, daß der nicht unerhebliche Aufwand zum Anfertigen der Freibohrungen der Halteplatte sowie deren genaue Ausrichtung auf dem Prüfling entfällt. Obwohl die Folie bei jeder Kontaktierung durchstoßen wird, bleibt deren Wirkung aufgrund ihres Anschmiegens/Haftens auf der Prüflingsoberfläche aufrechterhalten.

Vorzugsweise werden beide Oberflächen des Prüflings von einer Folie stabilisiert. Hiermit läßt sich bei beidseitiger Kontaktierung des Prüflings vollständig auf die Anfertigung von Freibohrungen in einer Halteplatte verzichten. Vorteilhafterweise werden die beiden Oberflächen des Prüflings von einer einzigen Folie stabilisiert, wobei vorzugsweise eine vollständige Umhüllung des Prüflings erfolgt.

In einer bevorzugten Ausführungsform wird die Folie mittels eines Vakuums auf den Prüfling aufgebracht. Hierbei ist es zum Beispiel in Durchgangsbohrungen von Durchgangskontaktierungen der Leiterplatte möglich, daß zwischen Prüfling und Folie ein Vakuum verbleibt, das gegenüber der zuvor genannten Folienstabilisierung eine weitere Stabilisierung des Prüflings bewirkt, indem das Vakuum die Folie besonders fest am Prüfling festlegt.

Eine zusätzliche Stabilisierung wird in diesem Fall noch durch den Einsatz der bereits erwähnten Halteplatte erzielt, die durch das Evakuieren fest an die Leiterplatte angedrückt wird und somit vollständig plan aufliegt.

Die zuvor genannte Aufgabe wird darüberhinaus erfindungsgemäß gelöst durch eine Haltevorrichtung, die mindestens einen Vakuumsauger aufweist. Durch das zwischen dem Vakuumsauger und der Oberfläche des Prüflings entstehende Vakuum wird eine sehr gute, feste Verbindung bewerkstelligt, die zum einen als Widerlager für die Kontaktierungskraft dient und zum anderen ein Nachschwingen nach der Kontaktierung verhindert. Der/die Vakuumsauger können in Randbereichen des Prüflings eingesetzt werden. Alternativ ist es auch möglich, hier eine mechanische Spanneinrichtung und in den verbleibenden Bereichen einen oder mehrere Vakuumsauger einzusetzen. Bevorzugt wird mindestens ein Vakuumsauger etwa im mittleren Bereich des Prüflings eingesetzt, da der Vakuumsauger dort eine sehr gute stabilisierende Wirkung hat. Bei der Anordnung des Vakuumsaugers ist es unerheblich, auf welcher Seite des Prüflings er sich befindet. Durch eine gute mechanische Fixierung des Vakuumsaugers selbst und die gute Verbindung zwischen Vakuumsauger und Prüfling wird sowohl eine Durchbiegung hin zum Vakuumsauger als auch weg von ihm verhindert.

Vorzugsweise ist der Vakuumsauger mittels eines Positionierelements in einer zur Oberfläche des Prüflings parallelen Ebene verfahrbar, so daß jeder beliebige Punkt auf der Oberfläche des Prüflings erreichbar ist. Somit läßt sich eine Abstützung des Prüflings im unmittelbaren Bereich der Kontaktierungsstelle erreichen. Vorzugsweise ist das Positionierelement mit einer Verlagerungseinrichtung versehen, mit der der Vakuumsauger zum Prüfling hin und von diesem weg bewegbar ist. Soll der Vakuumsauger beispielsweise vom Positionierelement bewegt werden, um eine neue Position einzunehmen, so hebt die Verlagerungseinrichtung den Vakuumsauger vorzugsweise nach Vakuumentfernung zunächst von der Oberfläche des Prüflings ab und setzt diesen an der neuen Position wieder auf der Oberfläche des Prüflings auf. Mit Hilfe einer Steuereinrichtung kann - wie erwähnt- das Saugen beim Abheben deaktiviert und beim anschließenden Aufsetzen auf den Prüfling wieder aktiviert werden.

Vorzugsweise bilden das Positionierelement für den Vakuumsauger und das Positionierglied für den Kontaktfinger eine Einheit. Damit wird bewerkstelligt, daß der Vakuumsauger mit dem Kontaktfinger mitbewegt wird und im unmittelbaren Bereich der Kontaktierungsstelle eingesetzt werden kann. Hierbei können Vakuumsauger und Kontaktfinger entweder direkt nebeneinander angeordnet sein, so daß die Kontaktierungsstelle neben dem vom Vakuumsauger abgestützten Bereich liegt. Andererseits läßt sich der Kontaktfinger beispielsweise auch innerhalb des Vakuumsaugers anordnen, so daß die Kontaktierungsstelle innerhalb des vom Vakuumsauger abgestützten Bereichs liegt.

Wie bereits erwähnt, ist es zur Erzielung einer guten Abstützung unerheblich, auf welcher Seite des Prüflings der Vakuumsauger angeordnet ist. Eine besonders gute Wirkung wird jedoch erzielt, wenn auf beiden Seiten jeweils Vakuumsauger eingesetzt werden.

Beim Einsatz von Vakuumsaugern ist allgemein dafür zu sorgen, daß sich im angesaugten Bereich des Prüflings keine Bohrung befindet, die das Entstehen eines Vakuums zwischen dem Prüfling und dem Vakuumsauger verhindern würde. Da das genaue Layout der Leiterplatte dem Prüfprogramm bekannt ist, läßt sich diese Forderung sehr leicht durch das Prüfprogramm erfüllen. Auch können die Vakuumsauger ihre programmgemäß bekannte Position aufgrund ihrer Verfahrbarkeit stets dann verändern, wenn sie im Arbeitsbereich der Kontaktfinger liegen. Bevor ein Kontaktfinger in diesem Arbeitsbereich aktiv wird, erfolgt der Positionswechsel des entsprechenden Vakuumsaugers zur Verhinderung von Kollisionen.

Da die Vakuumsauger in einer bevorzugten Weiterbildung der Erfindung zur Oberfläche des Prüflings hin- beziehungsweise von dieser wegbewegbar sind, kann diese Bewegung in einer weiteren Ausgestaltung der Erfindung auch zum Kontaktieren benutzt werden. Dabei müssen sich die Kontaktfinger nicht zum Prüfling hin bewegen, sondern der mittels der Vakuumsauger bewegte Prüfling wird mit einem bestimmten Kontaktierungsdruck auf den Kontaktfinger aufgesetzt.

Die Erfindung wird nun im folgenden anhand der Zeichnungen näher erläutert. Dabei zeigt
- Figur 1: eine schematische Draufsicht auf eine Kontaktierungsvorrichtung,
- Figur 2: eine schematische Draufsicht auf eine weitere Ausbildung einer Kontaktierungsvorrichtung,
- Figur 3 a, b, c: schematische Schnittansichten verschiedener Möglichkeiten einer erfindungsgemäßen Haltevorrichtung gemäß einem ersten Ausführungsbeispiel, und
- Figur 4 a, b: schematische schnittansichten einer erfindungsgemäßen Haltevorrichtung gemäß einem weiteren Ausführungsbeispiel.

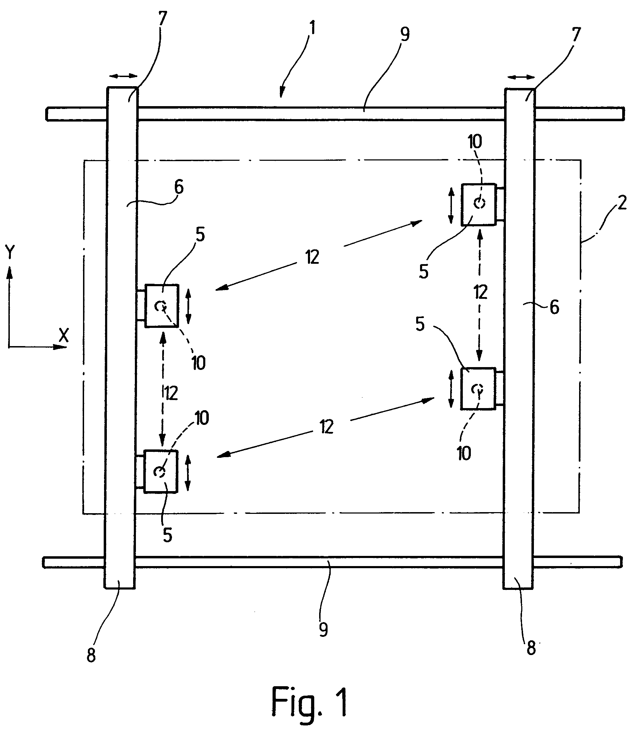

Die Figur 1 zeigt eine schematische Ansicht einer Kontaktierungsvorrichtung 1, wobei nur die für die Erfindung wesentlichen Komponenten dargestellt sind. Insofern sind ebenfalls für die Funktion dieser Vorrichtung erforderliche, jedoch für die Erfindung unwesentliche Teile weggelassen.

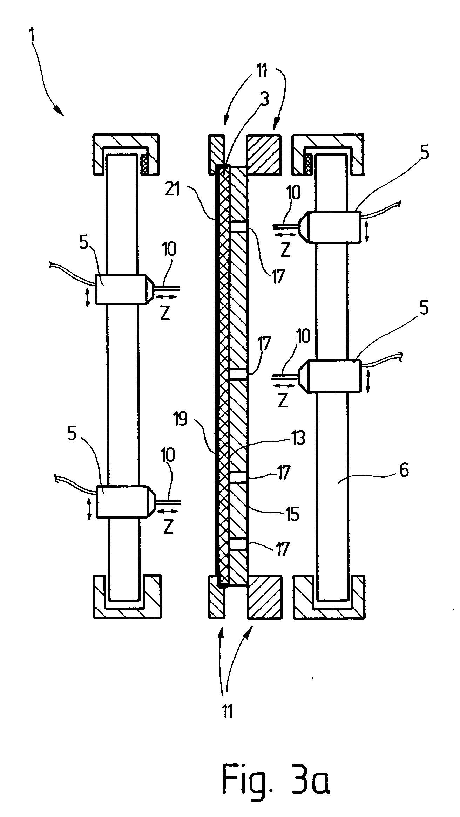

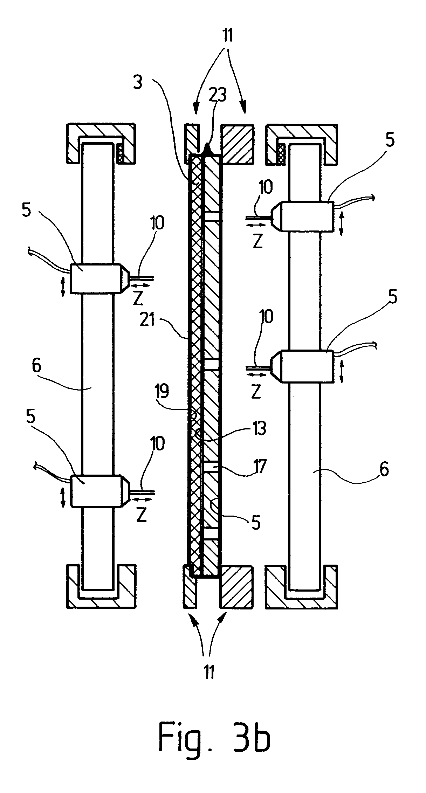

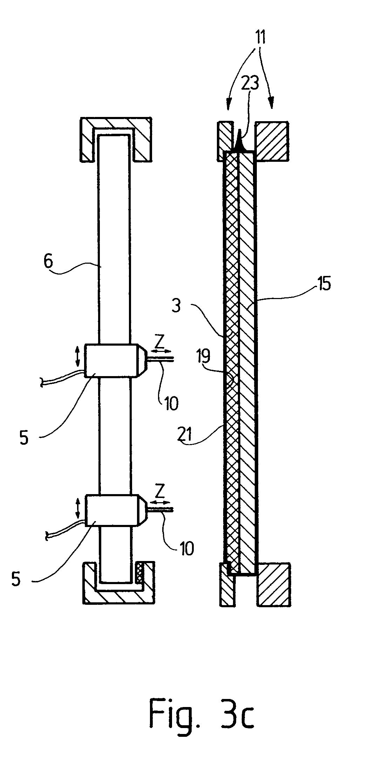

Die Kontaktierungsvorrichtung 1 weist ein Prüffeld 2 auf, das der Aufnahme eines Prüflings 3 dient (Figur 3). Bei dem Prüfling 3 handelt es sich vorzugsweise um eine mit Leiterbahnen versehene Leiterplatte. Diese Leiterplatte 3 ist mit einem Leiterbahn-Layout und einer Vielzahl von Bohrungen zur Aufnahme von elektronischen Bauteilen versehen (nicht dargestellt). Vor dem Bestücken der Leiterplatte 3 wird diese im Prüffeld 2 einer Isolations-, Kurzschluß- und/oder Widerstandsprüfung unterzogen, so daß nur die Leiterplatten 3, die einwandfreie Funktionen aufweisen, in einem weiteren Bearbeitungsschritt mit Bauelementen bestückt werden. Die defekten Leiterplatten 3 werden ausgesondert und gegebenenfalls einer Fehlerbehebung unterzogen.

Um die genannte elektrische Prüfung durchführen zu können, weist die Kontaktierungsvorrichtung 1 entlang von zwei, senkrecht zueinander verfahrbaren Koordinaten x, y verfahrbare Positionierglieder 5 auf. Hierzu wird das Prüffeld 2 von zwei Traversen 6 überspannt, wobei jede Traverse 6 in ihren Endbereichen 7 und 8 an Führungen 9 gelagert ist. Mittels einer nicht näher dargestellten Antriebseinrichtung läßt sich daher jede Traverse 6 entlang der Koordinate x verfahren.

Wie aus Figur 1 ersichtlich, sind an jeder Traverse 6 mindestens zwei Positionierglieder 5 verfahrbar angeordnet. Die Längserstreckung jeder Traverse 6 verläuft in Richtung der Koordinate y, so daß die Positionierglieder 5 in Richtung dieser Koordinate verlagerbar sind. Für das Verfahren der Positionierglieder 5 sind wiederum nicht dargestellte Antriebseinrichtungen vorgesehen.

Gemäß den Figuren 3 a, b, c weist jedes Positionierglied 5 einen Kontaktfinger 10 auf, der -beim Verfahren des zugehörigen Positionierglieds- vom Prüfling 3 beabstandet ist und -nach Erreichen der gewünschten Position des Positionierglieds 5- zur Kontaktierung auf eine gewünschte Kontaktstelle des Prüflings 3 aufgesetzt werden kann. Insofern ist jeder Kontaktfinger in Richtung der Koordinate z verlagerbar.

Vorzugsweise ist jedes Positionierglied 5 innerhalb eines bestimmten Bereichs in x-Richtung verlagerbar, ohne die Traverse 6 zu bewegen. Das heißt, bei einer stehenden Traverse 6 kann das Positionierglied 5 beliebige, innerhalb des genannten, sich in x-Richtung erstreckenden Bereichs liegende, Kontaktierungsstellen anfahren.

Bei der Kontaktierungsvorrichtung 1 ist vorgesehen, daß von den mit Kontaktfingern 10 versehenen Positioniergliedern 5 mehrere Sondenpaare 12 gebildet werden. Dies ist beispielsweise in der Figur 1 angedeutet; dort bilden die oberen beiden Positionierglieder 5 der beiden Traversen 6 ein erstes Sondenpaar 12 und die unteren beiden Positionierglieder 5 ein zweites Sondenpaar 12. Es ist jedoch -je nach dem vorliegenden Programmprüfungsschrittmöglich, daß die beiden Positionierglieder 5 der selben Traverse 6 für diesen bestimmten Programmschritt ein Sondenpaar 12 bilden (dies ist in der Figur 1 mit gestrichelten Doppelpfeilen gekennzeichnet).

Durch die Vielzahl der Sondenpaare 12 ist innerhalb eines Positionierschritts eine entsprechende Anzahl von Prüfstromkreisen ausbildbar. Unter Prüfstromkreis ist hier eine elektrische Prüfung entlang eines Strompfads zu verstehen, der -von einer nicht dargestellten Auswerteelektronik kommend- zu einem der Positionierglieder 5 führt, über den Prüfling 3 verläuft und über das zum betrachtenden Sondenpaar 12 zugehörige Positionierglied 5 zur Auswerteelektronik zurückführt. Ein weiterer entsprechender Prüfstromkreis wird zwischen den verbleibenden Positioniergliedern 5 ausgebildet, so daß -je nach Anzahl der Positionierglieder 5 und damit der möglichen Prüfstromkreise- gleichzeitig eine Vielzahl von Prüfungen durchführbar ist.

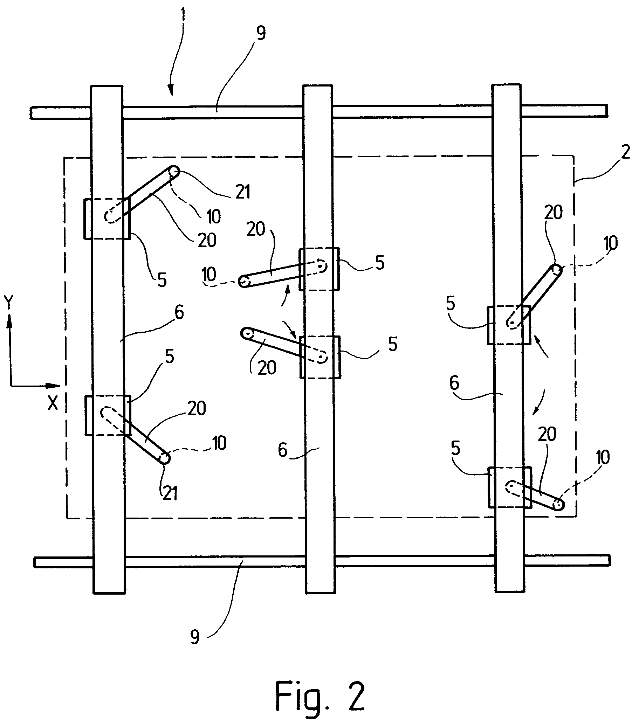

Die Figur 2 zeigt ein weiteres Ausführungsbeispiel einer Kontaktierungsvorrichtung 1, das sich gegenüber dem Ausführungsbeispiel der Figur 1 dadurch unterscheidet, daß die Positionierglieder 5 mit Schwenkarmen 20 versehen sind. Die einzelnen Positionierglieder 5 sind an Traversen 6 in Richtung der y-Koordinate verfahrbar. Vorzugsweise sind jeder Traverse 6 zwei Positionierglieder 5 zugeordnet. Es können jedoch auch mehr als zwei gewählt werden. Die Traversen 6 lassen sich entlang der Führungen 9 in Richtung der x-Koordinate verfahren.

Jeder Schwenkarm 20 ist an seinem einen Ende am zugehörigen Positionierglied 5 gelagert und in einer parallel zum Prüffeld 2 liegenden Ebene verschwenkbar, wobei der Schwenkwinkel vorzugsweise 360° beträgt. Am freien Ende 21 jedes Schwenkarms 20 ist wiederum ein Kontaktfinger 10 angeordnet, der in Richtung der z-Koordinate auf das Prüffeld 2 zum Kontaktieren einer Kontaktstelle eines Prüflings abgesenkt werden kann. Dabei besteht die Möglichkeit, daß sich der Kontaktfinger 10 absenkt oder daß der gesamte Schwenkarm 20 oder die Positioniervorrichtung 5 verlagert wird.

Selbstverständlich kann das Positionieren der Positionierglieder und des Kontaktfingers auch derart erfolgen, daß das Positionierglied und der Kontaktfinger ortsfest angeordnet sind und statt dessen der Prüfling verlagert wird, um die Kontaktierungsstelle anzufahren. Der Prüfling führt folglich eine Bewegung in der x-y-Ebene als auch in der z-Richtung aus.

Es ist natürlich auch möglich, die genannten Vorrichtungen zum Anfahren von Kontaktierungsstellen beliebig zu kombinieren.

Die Figuren 3 a - c zeigen jeweils eine Schnittansicht der in Figur 1 gezeigten Kontaktierungsvorrichtung.

Es ist insbesondere der Figur zu entnehmen, daß die den Prüfling 3 bildende Leiterplatte in vertikaler Stellung, das heißt, mit vertikaler Leiterplattenebene, in der Kontaktierungsvorrichtung 1 zur Durchführung der Prüfung angeordnet wird. Hierzu sind geeignete Halte- beziehungsweise Befestigungsmittel 11 vorgesehen, die während des Prüfvorgangs die Leiterplatte 3 halten.

Wie bereits erwähnt, werden die Kontaktfinger 10 zum Kontaktieren der Kontaktstelle auf der Leiterplatte 3 in z-Richtung verlagert, wie dies in Figuren 3 angedeutet ist. Für eine sichere Kontaktierung muß der Kontaktfinger 10 mit einem bestimmten Kontaktdruck auf die Kontaktstelle aufgesetzt werden. Die dem Kontaktdruck entgegengerichtete Kraft wird zunächst von den Haltemitteln 11 erbracht, die die Leiterplatte 3 an den Randbereichen festhalten, um ein Ausweichen der Leiterplatte 3 zu verhindern. Insbesondere bei Leiterplatten 3 mit geringer Dicke genügt die alleinige Fixierung an den Randbereichen durch die Haltemittel 11 nicht mehr, da die Leiterplatte 3 insbesondere in mittleren Bereichen nicht die nötige Festigkeit beziehungsweise Starrheit aufbringt, um dem Kontaktierungsdruck standzuhalten. Die Folge ist eine zumindest geringe Durchbiegung der Leiterplatte 3.

Da die Kontaktierungsgeschwindigkeit relativ hoch ist, also der Zeitabstand zwischen zwei Kontaktierungen gering ist, kann die Leiterplatte 3 unter Umständen in Schwingungen geraten, die eine sichere Kontaktierung nicht mehr gewährleisten.

Um der Leiterplatte 3 eine zusätzliche flächenhafte Stabilisierung beziehungsweise Abstützung zu verleihen, ist an einer Seite 13 der Leiterplatte 3 eine Halte- beziehungsweise Abstützplatte 15 vorgesehen. Diese Halteplatte 15 liegt auf der einen Seite 13 der Leiterplatte 3 möglichst plan auf und wird ebenfalls über die Haltemittel 11 ortsfest fixiert.

Da in dem gezeigten Ausführungsbeispiel eine zweiseitige Kontaktierung vorgesehen ist, weist die Halteplatte 15 sogenannte Freibohrungen 17 auf, deren Durchmesser so gewählt sind, daß ein Kontaktfinger 10 hindurchgreifen kann. Die Plazierung dieser Freibohrungen 17 auf der Halteplatte 15 geschieht abhängig von der Position der zu prüfenden Kontaktstellen auf der Leiterplatte 3.

Die Halteplatte 15 selbst ist aus einem Material gefertigt, daß zum einen nicht elektrisch leitend ist und zum anderen eine hohe Steifigkeit aufweist.

Auf der der Seite 13 gegenüberliegenden Seite 19 der Leiterplatte 3 ist eine Folie 21 als weiteres Stabilisierungselement vorgesehen. Die Folie 21 ist vorzugsweise aus Kunststoff gebildet und weist eine möglichst geringe Elastizität auf. Sie wird in geeigneter Weise über die Oberfläche 19 der Leiterplatte 3 gespannt. Die Folie 21 schmiegt sich dabei an die Oberfläche an. Die Fixierung des mit der Folie versehenen Prüflings erfolgt mit Haltemitteln 11, die in dem in Figur 3 a gezeigten Ausführungsbeispiel die Anordnung aus Folie 21, Leiterplatte 3 und Halteplatte 15 einspannen.

Aufgrund der guten Verbindung zwischen Folie 21 und Leiterplatte 3 wird eine zusätzliche Stabilisierungswirkung mit relativ geringem Aufwand erreicht. Die gute Stabilisierungswirkung der Folie 21 ergibt sich im wesentlichen aus deren geringer Elastizität. Wird die Leiterplatte 3 beim Kontaktieren mit dem Kontaktierungsdruck beaufschlagt, versucht die Leiterplatte 3 diesem Druck nachzugeben, durchzubiegen und die Folie damit zu dehnen. Da die Folienelastizität gering ist, ist die der Durchbiegung entgegenwirkende Kraft groß, so daß eine Durchbiegung im wesentlichen verhindert wird.

Das Material der Folie 21 muß so beschaffen sein, daß es ein Durchstoßen der Kontaktfinger 10 zuläßt. Dies ist erforderlich, weil die Folie 21 keine den Freibohrungen 17 entsprechenden Löcher aufweist. Die Kontaktfinger 10 müssen zum Kontaktieren der Kontaktstellen zunächst die Folie 21 durchdringen, bevor sie einen elektrischen Kontakt herstellen können.

Figur 3 b zeigt eine weitere Möglichkeit, die Leiterplatte 3 zu stabilisieren. Dabei sind die den in Figur 3 a entsprechenden Teile mit den gleichen Bezugszeichen bezeichnet, weshalb auf deren nochmalige Beschreibung verzichtet wird.

Der einzige Unterschied zu der in Figur 3 a gezeigten Ausführungsform besteht in der Ausbildung der Folie 21.

Die Folie 21 umschließt die Anordnung von Leiterplatte 3 und Halteplatte 15 in dem in Figur 3 b gezeigten Ausführungsbeispiel vollständig. In dieser Figur ist dabei die Verbindungsstelle der beiden Folienenden schematisch dargestellt und mit der Bezugsziffer 23 bezeichnet. Die Verbindung kann dabei beispielsweise über ein Verschweißen der Folienenden erfolgen.

Durch die beidseitige Anordnung der Folie 21 wird der in Zusammenhang mit der Figur 3 a bereits beschriebene Stabilisierungseffekt nochmals gesteigert. Nach einem nicht dargestellten Ausführungsbeispiel ist es auch möglich, den Prüfling nur mittels der Folie 21 zu stabilisieren, also keine Halteplatte vorzusehen.

Aus der Figur 3 b ist darüberhinaus ersichtlich, daß die der Leiterplattenseite 13 zugeordneten Kontaktfinger 10 zunächst die Folie 21 durchdringen müssen, um dann anschließend die Freibohrungen 17 der Halteplatte 15 zu durchgreifen und den elektrischen Kontakt herzustellen.

Die in Figur 3 c gezeigte Kontaktierungsvorrichtung kann nur eine Seite des Prüflings 3 prüfen, denn die Halteplatte 15 weist keine Freibohrungen 17 auf. Die Folie 21 ist nach Art einer Tüte ausgebildet, in die zumindest der Prüfling eingebracht und die dann evakuiert wird.

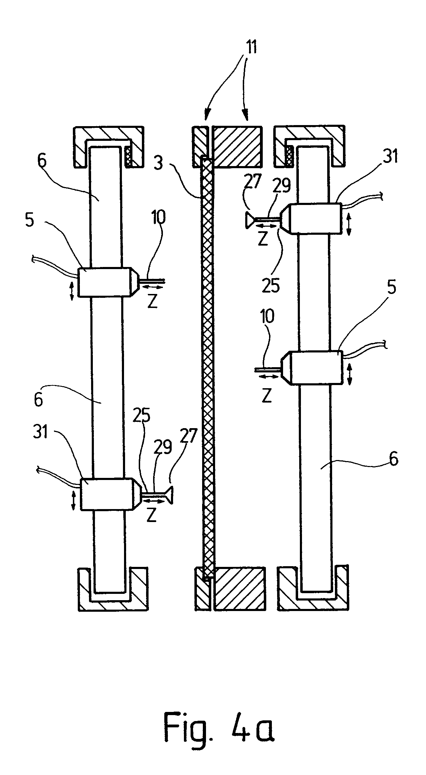

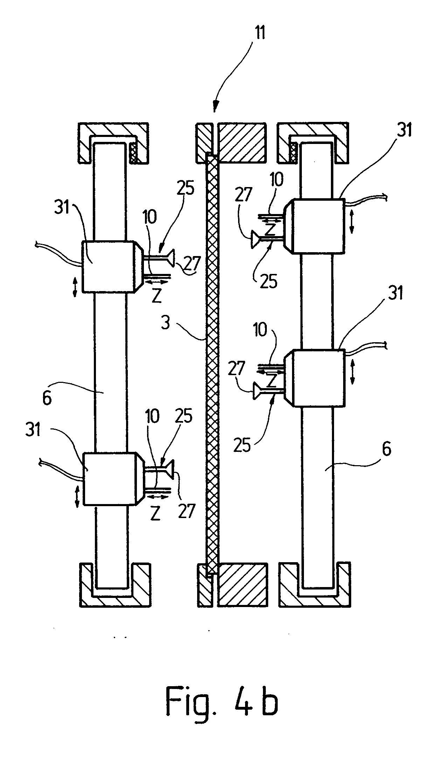

Eine weitere Möglichkeit, die erfindungsgemäße Aufgabe zu lösen, ist in der Anordnung gemäß Figur 4 a zu sehen. Dabei entspricht der Grundaufbau dieses Ausführungsbeispiels dem vorhergehenden, weshalb auf eine genaue Beschreibung der einzelnen Teile verzichtet wird. Diese neue Möglichkeit kann auch mit der Folienlösung kombiniert werden.

Die Leiterplatte 3 ist randseitig in den Haltemitteln 11 fest eingespannt. Eine Abstützung und Stabilisierung der Leiterplatte 3 wird durch Vakuumsauger 27 erzielt.

Die Vakuumsauger 27 sind als Ansaugnäpfe ausgebildet und lassen sich mittels jeweils einer Stange 25 oder ähnlichem in z-Richtung, also zur Leiterplatte 3 hin beziehungsweise von dieser weg verlagern. Diese Ansaugnäpfe 27 bestehen aus einem vorzugsweise elastischen Material, das sich beim Aufsetzen auf die Leiterplatte 3 an die Oberfläche anschmiegt und eine gute Abdichtung gewährleistet. Der von einem Ansaugnapf 27 umschlossene Raum ist über eine entsprechende Leitung 29 mittels einer entsprechenden Vakuumpumpe evakuierbar. Dadurch entsteht eine feste Verbindung zwischen dem Vakuumsauger 27 und der Leiterplatte 3.

Der Vakuumsauger 27 ist über ein Positionierelement 31 auf der Traverse 6 in gleicher Weise wie das Positionierglied 5 verlagerbar. Zusammen mit der Verlagerbarkeit der Traverse 6 in x-Richtung ist jeder beliebige Punkt der Leiterplatte 3 vom Positionierelement 31 erreichbar. Vorzugsweise befindet sich das Positionierelement 31 jedoch im unmittelbaren Bereich des Positionierglieds 5, so daß der durch den Kontaktfinger 10 kontaktierte Bereich vom Vakuumsauger 27 abgestützt werden kann.

Während der Neupositionierung des Positionierelements 31 ist der Vakuumsauger 27 deaktiviert. Die entsprechende Aktivierungs- beziehungsweise Deaktivierungs-Steuerung erfolgt über eine Steuerelektronik, die in den Figuren nicht gezeigt ist.

Da die Leiterplatte 3 über eine Vielzahl von Bohrungen verfügt, muß das Prüfprogramm dafür sorgen, daß das Positionierelement 31 nur solche Positionen anfährt, an denen die Leiterplatte 3 keine Bohrungen aufweist, so daß eine Evakuierung möglich ist.

Selbstverständlich können auch mehrere Vakuumsauger 27 auf beiden Seiten der Leiterplatte 3 vorgesehen sein.

Figur 4 b zeigt eine Abänderung des Positionierelementes 31. Entsprechend diesem Ausführungsbeispiel weist das Positionierelement 31 auch einen Kontaktfinger 10 auf. Somit liegt eine Zusammenfassung von Positionierglied 5 und Positionierelement 31 zu einem gemeinsamen Positionierelement 31 vor. Damit kann der Vakuumsauger 27 automatisch mit der Positionierbewegung des Kontaktfingers 10 mitbewegt werden und auf diese Weise immer im unmittelbaren Bereich der Kontaktierungsstelle die Leiterplatte 3 abstützen.

Selbstverständlich kann der Bewegungsablauf des Kontaktierens -wie erwähnt- auch umgekehrt werden, das heißt, daß die Leiterplatte 3 zum Kontaktfinger 10 bewegt wird. Hierbei können die Vakuumsauger 27 zusätzlich dazu dienen, die Leiterplatte 3 zum Kontaktfinger 10 zu führen und von diesem wiederum wegzubewegen, wobei die bereits erwähnte Verlagerbarkeit der Vakuumsauger in z-Richtung dafür ausgenutzt wird.

## Patentansprüche

1. Haltevorrichtung für flächenförmige Prüflinge, insbesondere Leiterplatten, die mittels einer elektrischen Kontaktierungsvorrichtung für Prüfzwecke von Kontaktfingern (10) verfahrbarer Positionierglieder (5) kontaktiert werden, wobei die Haltevorrichtung (11;15) den Prüfling (3) auf seine beiden, einander gegenüberliegenden Oberflächen mit Haltemitteln abstützt, **dadurch gekennzeichnet**, daß mindestens eines der Haltemittel als elektrisch nicht leitende, von den Kontaktfingern (10) durchstoßbare Folie (21) ausgebildet ist.

2. Haltevorrichtung nach Anspruch 1, **dadurch gekennzeichnet**, daß beide Haltemittel als Folie (21) ausgebildet sind.

3. Haltevorrichtung nach einem der vorhergehenden Ansprüche, **dadurch gekennzeichnet**, daß die beiden Folien (21) als einstückige, den Prüfling (3) vorzugsweise vollständig umschließende Folie ausgebildet ist.

4. Haltevorrichtung nach einem der vorhergehenden Ansprüche, **dadurch gekennzeichnet**, daß die eine Oberseite (13) des Prüflings (3) von einer Abstützplatte (15) abgestützt ist und daß auf der anderen Oberseite (19) eine Folie (21) angeordnet ist.

5. Haltevorrichtung nach einem der vorhergehenden Ansprüche, **dadurch gekennzeichnet**, daß die Abstützplatte (15) Freibohrungen (17) für die Kontaktierung aufweist.

6. Haltevorrichtung nach einem der vorhergehenden Ansprüche, **dadurch gekennzeichnet**, daß die Folie (21) mittels Vakuum und/oder einem Verschweißvorgang dem Prüfling (3) zugeordnet wird.

7. Haltevorrichtung für flächenförmige Prüflinge, insbesondere Leiterplatten, die mittels einer elektrischen Kontaktierungsvorrichtung für Prüfzwecke von Kontaktfingern verfahrbarer Positionierglieder kontaktiert werden, **dadurch gekennzeichnet**, daß die Haltevorrichtung mindestens einen Vakuumsauger (27) aufweist.

8. Haltevorrichtung nach Anspruch 7, **dadurch gekennzeichnet**, daß der Vakuumsauger (27) mittels einer Steuereinrichtung zum Saugen aktiviert beziehungsweise deaktiviert werden kann.

9. Haltevorrichtung nach Anspruch 7 oder 8, **dadurch gekennzeichnet**, daß der Vakuumsauger (27) mittels eines Positionierelements (31) verfahrbar ist.

10. Haltevorrichtung nach einem der Ansprüche 7 bis 9, **dadurch gekennzeichnet**, daß der Vakuumsauger (27) mittels einer Verlagerungseinrichtung des Positionierelements (31) in Richtung auf den Prüfling verlagerbar beziehungsweise von diesem wegbewegbar ist.

11. Haltevorrichtung nach einem der Ansprüche 7 bis 10, **dadurch gekennzeichnet**, daß das Positionierglied (5) von dem Positionierelement (31) gebildet ist.

12. Haltevorrichtung nach einem der Ansprüche 7 bis 11, **dadurch gekennzeichnet**, daß auf beiden Oberflächen des Prüflings (3) Vakuumsauger (27) angeordnet sind.

13. Haltevorrichtung nach einem der Ansprüche 7 bis 12, **dadurch gekennzeichnet**, daß der Prüfling (3) mittels der Vakuumsauger (27) zu den Kontaktfingern (10) hin verlagerbar beziehungsweise von diesen weg bewegbar ist.
